# EUROPÄISCHE PATENTSCHRIFT

(11) **EP 3 803 984 B1**
(45) Veröffentlichungstag und Bekanntmachung des Hinweises auf die Patenterteilung: **10.08.2022**
(21) Anmeldenummer: 19729712.0
(22) Anmeldetag: 05.06.2019
(51) Int. Cl.: H01L 31/048, H01L 31/049, H02S 20/30

(54) **PHOTOVOLTAISCH AKTIVES LAMINAT**
PHOTOVOLTAICALLY ACTIVE LAMINATE
STRATIFIÉ À ACTION PHOTOVOLTAÏQUE

(30) Priorität: 08.06.2018 DE 102018209112
(43) Veröffentlichungstag der Anmeldung: 14.04.2021
(73) Patentinhaber: AUDI AG, 85045 Ingolstadt (DE)
(72) Erfinder: BRYMERSKI, Wojciech, 70806 Kornwestheim (DE); MATTHAI, Annegret, 85296 Rohrbach (DE)
(86) Internationale Anmeldenummer: PCT/EP2019/064670
(87) Internationale Veröffentlichungsnummer: WO 2019/234105

(56) Entgegenhaltungen:
- EP-A1- 2 204 281
- DE-A1-102008 038 647
- DE-A1-102009 034 794
- US-A1- 2007 125 417

## Beschreibung

Die Erfindung betrifft ein photovoltaisch aktives Laminat.

Bei rein elektrisch fahrenden Fahrzeugen oder bei Hybridfahrzeugen, die zumindest teilelektrisch fahren, ist ein oder sind mehrere Energiespeicher vorgesehen, die von Zeit zu Zeit zu laden sind. Hierzu ist es, neben der üblichen Ladetechnik über ein Ladekabel oder durch induktives Laden, bekannt, an die Fahrzeugaußenhaut bildenden Bauteilen wie beispielsweise einem Panoramadach oder einem Panoramaschiebedach Solarzellen vorzusehen. Diese Solarzellen werden üblicherweise in Bauteilen aus Glas, wie eben dem genannten Panorama- oder Panoramaschiebedach verbaut, wobei der Aufbau eines solchen Glasdachmoduls aus einer oberen und einer unteren Glasschicht besteht, zwischen denen die Solarzellen eingebracht sind. Bei diesem Sandwichaufbau befindet sich die Solarzellenebene quasi in der Mitte des Sandwichaufbaus, wobei zwischen der Solarzellenebene und der oberen und unteren Glasebene jeweils oder ein oder mehrere Trägerfolien eingebracht sind. Der gesamte Aufbau ist starr, nachdem das Panorama- oder Panoramaschiebedach die Funktion eines zentralen, stabilen Dachmoduls hat.

Der Erfindung liegt das Problem zu Grunde, ein photovoltaisch aktives Bauteil anzugeben, das in seiner Handhabung und Verwendungsmöglichkeit flexibler ist. Beispiele von bekannten phovoltaischen Bauteilen, werden in den Patentveröffentlichungen US 2007/125417 A1 und EP 2204281 A1 beschrieben.

Zur Lösung dieses Problems ist erfindungsgemäß ein photovoltaisch aktives Laminat vorgesehen, mindestens umfassend eine die Laminatoberseite bildende, für einfallende Lichtstrahlung transparente Deckfolie, eine photovoltaisch aktive Solarzellenfolie sowie eine Trägerschicht aus einem Faserverbundwerkstoff.

Erfindungsgemäß wird ein photovoltaisch aktives Laminat vorgeschlagen, das äußerst dünn ist und insgesamt flexibel ist. Das heißt, dass es auf Grund seiner Flexibilität an der Kraftfahrzeugaußenhaut angebracht werden kann, auch wenn diese nicht ebenflächig ist, sondern, wie beispielsweise im Falle einer Frontklappe bzw. Motorhaube, einer Heckklappe, Türen etc., gewölbt ist oder entsprechende engere Radien etc. aufweist. Dieses flexible Laminat kann daher an unterschiedlichen Positionen an dem Fahrzeug angebracht werden, wobei diese Montage auch nachträglich erfolgen kann. Selbstverständlich kann das photovoltaisch aktive Laminat auch an anderen Gegenständen montiert werden, das heißt, dass seine Verwendung nicht auf den Kraftfahrzeugsektor beschränkt ist.

Das erfindungsgemäße Laminat umfasst eine für die einfallende Lichtstrahlung transparente Deckfolie, die die Laminatoberseite bildet. Diese Deckfolie ist bevorzugt aus PU (Polyurethan), SAN (Styrol-Acrylnitril), PC (Polycarbonat) oder PA (Polyamid), wobei aber auch andere Kunststofffolien verwendet werden können, die die gewünschten mechanischen und insbesondere Transparenzeigenschaften aufweisen. Denn die Deckfolie muss für die einfallende Lichtstrahlung, die von der innerhalb des Laminatsandwich befindlichen Solarzellenfolie gewandelt werden soll, transparent sein, das heißt, dass sie so wenig wie möglich absorptiv wirken soll. Diese Deckfolie ist wie beschrieben hinreichend stabil und kann als Lackersatz dienen, wenn das erfindungsgemäße Laminat unmittelbar auf das entsprechende Karosseriebauteil vor dessen Lackierung gebracht. Hierzu kann die Deckfolie auch eingefärbt sein, um entsprechenden Farbwünschen Rechnung zu tragen.

Das Laminat umfasst des Weiteren eine photovoltaisch aktive Solarzellenfolie, also eine äußerst dünne Folie mit daran entsprechend ausgebildeten Solarzellen. Solche flexiblen Solarzellenfolien bestehen aus einer extrem dünnen Trägerfolie beispielsweise aus Polyimid, auf die eine photovoltaisch aktive Schicht beispielsweise aus Cadmiumtellurid (CdTe) aufgebracht wird, die gegebenenfalls rückseitig von einer weiteren extrem dünnen Trägerfolie beispielsweise aus Polyimid eingefasst ist. Der gesamte Folien- oder Schichtaufbau ist extrem dünn und daher äußerst flexibel.

Des Weiteren umfasst das erfindungsgemäße Laminat eine dünne, flexible Trägerschicht aus einem Faserverbundwerkstoff, die dem Laminat eine hinreichende Stabilität verleiht. Diese Trägerschicht kann beispielsweise aus glasfaserverstärktem oder kohlefaserverstärktem Kunststoff sein, wobei auch eine solche Trägerschicht äußerst dünn hergestellt werden kann, so dass sich insgesamt ein extrem dünner Laminataufbau ergibt, der die vorteilhafte Flexibilität ermöglicht.

Das erfindungsgemäße Laminat ist demzufolge auch äußerst leicht, verglichen mit bisher bekannten Solarbauteilen umfassend eine oder mehrere Glasebenen, was beispielsweise bei Anwendung im KFZ-Bereich zu einem geringeren Gesamtgewicht führt, verbunden mit der Möglichkeit, eine wesentliche größere Solarfläche auf Grund der Anbringungsmöglichkeit an verschiedenartig geformten Fahrzeugaußenflächen zu ermöglichen.

Die Deckfolie selbst weist eine Dicke von bis zu 1 mm auf. Es kann sich, wie ausgeführt, um eine transparente Folie handeln, sie kann aber auch eingefärbt sein, stets aber muss eine hinreichend hohe Licht- respektive Strahlungstransparenz gegeben sein, so dass das Licht möglichst ungeschwächt auf die Solarzellenfolie trifft und diese mit hinreichend hohem Wirkungsgrad die Lichtenergie in elektrische Energie umwandeln kann.

Die Solarzellenfolie selbst weist eine Dicke von wenigstens 0,06 mm, insbesondere zwischen 0,06-2 mm auf. Bevorzug liegt die Dicke im Bereich von ca. 0,3-0,5 mm.

Die Trägerschicht weist eine Dicke zwischen 0,8-3 mm auf.

Je dünner die einzelnen Folien/Schichten gewählt werden, umso flexibler ist natürlich der Laminataufbau.

Gemäß einer ersten Erfindungsalternative kann das erfindungsgemäße Laminat lediglich aus der Deckfolie, der Solarzellenfolie und der Trägerschicht bestehen. In diesem Fall ist die Deckfolie direkt auf der Solarzellenfolie aufgebracht und die Solarzellenfolie wiederum direkt auf der Trägerschicht.

Alternativ dazu besteht die Möglichkeit, wenigstens eine Zwischenfolie vorzusehen, die zwischen der Deckfolie und der Trägerschicht angeordnet ist. Über diese Zwischenfolie kann die Solarzellenfolie an einer Seite eingefasst werden, sie dient quasi als Schutzfolie, um die Solarzellenfolie von entweder der Deckfolie oder der Trägerschicht geringfügigst zu beabstanden, wobei die Zwischenfolie ebenfalls eine geringstmögliche Dicke aufweist, sie sollte eine Dicke von wenigstens 0,1 mm aufweisen, und bevorzugt zwischen 0,1-1 mm dick sein.

Bevorzugt ist die Zwischenfolie zwischen der Solarzellenfolie und der Trägerschicht angeordnet, sie dient also der Abschirmung der Solarzellenfolie zur GFK (glasfaserverstärkter Kunststoff) - oder CFK (kohlefaserverstärkter Kunststoff)-Trägerschicht. Zusätzlich kann auch zwischen der Deckfolie und der Solarzellenfolie eine Zwischenfolie angeordnet sein, das heißt, dass die Solarzellenfolie beidseits über jeweils eine Trägerfolie eingefasst und zur jeweils benachbarten Deckfolie bzw. Trägerschicht abgeschirmt ist.

Die Zwischenfolie selbst kann dabei aus demselben Material wie die Deckfolie sein, das heißt, sie kann beispielsweise auch aus PU, SAN, PC oder PA sein. Bevorzugt wird jedoch eine Zwischenfolie aus PVB (Polyvinylbutyral) verwendet.

Um eine möglichst einfache Montage des erfindungsgemäßen Laminats auf einem Untergrund zu ermöglichen, ist das Laminat mit einem auf der Trägerschicht befindlichen Klebemittel zu versehen, über das das Laminat auf einer Fläche verklebbar ist, wobei das Klebemittel mit einer abziehbaren Schutzfolie, beispielsweise einem Silikonpapier, belegt ist. Das heißt, dass das Laminat bereits werkseitig mit einem entsprechenden Klebemittel ausgerüstet ist.

Als Klebemittel kann beispielsweise ein unmittelbarer Klebstoffauftrag vorgesehen sein, der auf die Trägerschicht beispielsweise aufgesprüht oder mittels eines Kalanders oder ähnlichem aufgebracht wird. Alternativ kann als Klebemittel auch eine Klebefolie, insbesondere eine doppelseitige Klebefolie verwendet werden, die ebenfalls beispielsweise mittels eines Kalanders aufgebracht wird.

Neben dem erfindungsgemäßen photovoltaisch aktiven Laminat betrifft die Erfindung ferner ein Kraftfahrzeug, bei dem wenigstens eine Außenfläche mit einem photovoltaisch aktiven Laminat der beschriebenen Art belegt ist.

Dabei kann das Laminat mittels eines Klebemittels, insbesondere einer Klebefolie, auf die die Außenfläche geklebt sein.

Weitere Vorteile und Einzelheiten der vorliegenden Erfindung ergeben sich aus den im Folgenden beschriebenen Ausführungsbeispielen sowie anhand der Zeichnungen. Dabei zeigen:
- Fig. 1: eine Prinzipdarstellung, geschnitten, durch ein erfindungsgemäßes Laminat einer ersten Ausführungsform,
- Fig. 2: eine Prinzipdarstellung, geschnitten, durch ein erfindungsgemäßes Laminat einer zweiten Ausführungsform,
- Fig. 3: eine Prinzipdarstellung, geschnitten, durch ein erfindungsgemäßes Laminat einer dritten Ausführungsform, und
- Fig. 4: eine Prinzipdarstellung eines erfindungsgemäßen Kraftfahrzeugs.

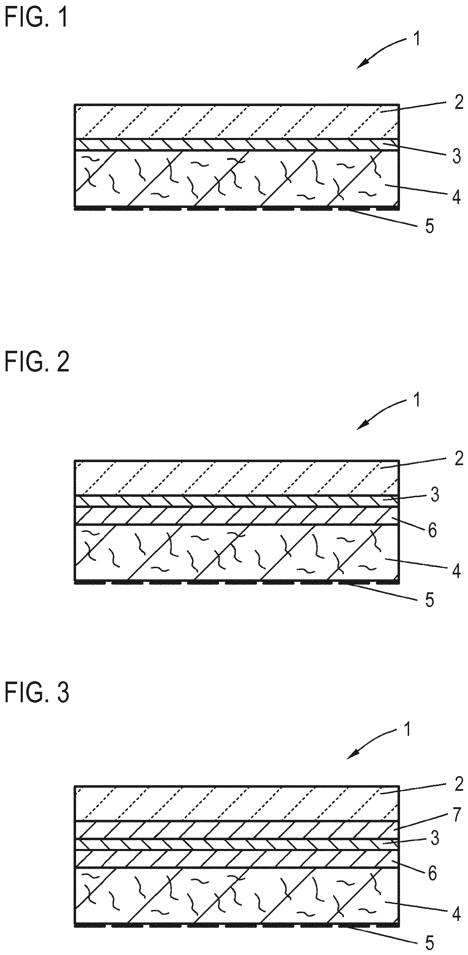

Fig. 1 zeigt ein erfindungsgemäßes Laminat 1 in Form einer Prinzipdarstellung. Dieses besteht aus einer Deckfolie 2, beispielsweise aus PU, PC, SAN oder PA. Die Deckfolie 2 ist transparent, kann aber auch eingefärbt sein. In jedem Fall ist sie für einfallende Lichtstrahlung transparent, so dass diese möglichst ungeschwächt durch die Deckfolie 2 hindurchtreten kann. Anstelle der genannten Folienarten kann aber auch ein anderes amorphes Kunststoffmaterial verwendet werden, solange es hinreichend stabil ist und hinreichen transparent ist, gleichwohl aber flexibel ist.

Die Deckfolie 2 ist auf einer Solarzellenfolie 3 aufgebracht, die eine Dicke von mindestens 0,06 mm, bevorzugt eine Dicke von ca. 0,3-0,5 mm aufweist. Es kann sich dabei um eine Polyimidfolie handeln, auf die in extrem dünner Beschichtung ein photovoltaisch aktives Material, beispielsweise Cadmiumtellurid, aufgebracht wird. Aber auch andere photoaktive Materialien oder Trägerfolien sind denkbar. In jedem Fall ist auch diese Solarzellenfolie extrem dünn und flexibel.

Die Solarzellenfolie 3 wiederum ist auf einer Trägerschicht 4 aus glasfaser- oder kohlenfaserverstärktem Verbundwerkstoff aufgebracht, wobei diese Trägerschicht ebenfalls extrem dünn und flexibel ist. Sie weist eine Dicke von ca. 0,8-3 mm auf. Insgesamt entsteht so ein äußerst dünner Laminataufbau, der äußerst leicht und flexibel ist, so dass er an unterschiedlichen geometrischen Gegenständen, beispielsweise an der Außenhaut einer Kraftfahrzeugkarosserie, trotz deren Wölbungen etc. angebracht werden kann.

Zur leichteren Montage ist das Laminat 1 von Haus aus mit einem Klebemittel 5, das auf der Trägerschicht 4 aufgebracht ist, zu versehen.

Bei dem Klebemittel 5 kann es sich beispielsweise um einen direkten Klebstoffauftrag handeln, der mit einer abziehbaren Schutzfolie beispielsweise mit einem Silikonpapier belegt ist, es kann sich aber auch um eine doppelseitige Klebefolie handeln, die ebenfalls mit einer solchen Schutzfolie belegt ist.

Über dieses Klebemittel 5 kann das erfindungsgemäße Laminat ohne Weiteres auf der gewünschten Fläche verklebt werden.

Fig. 2 zeigt eine weitere Ausführungsform eines erfindungsgemäßen Laminats 1, wiederum bestehend aus einer Deckfolie 2 der vorstehend beschriebenen Art. Ebenfalls vorgesehen ist eine Solarzellenfolie der vorgeschriebenen Art, auf welcher die Deckfolie 2 aufgebracht ist.

Anders als bei der Ausgestaltung gemäß Fig. 1 ist die Solarzellenfolie auf einer Zwischenfolie 6 aufgebracht, die ebenfalls äußerst dünn ist, sie weist bevorzugt eine Dicke von 0,1-1 mm auf. Es handelt sich bevorzugt um eine PVB-Folie, gleichwohl kann diese Zwischenfolie aber auch es demselben Kunststoffmaterial sein wie die Deckfolie 2. Diese Zwischenfolie dient der Abschirmung der Solarzellenfolie 3 zur Trägerschicht 4 hin, das heißt, dass die Zwischenfolie 6 auf der Trägerschicht 4 aufgebracht ist, die vorstehend bereits zu Fig. 1 beschrieben wurde.

Auch hier ist ein Klebemittel 5 auf der Trägerschicht 4 aufzubringen.

Fig. 3 zeigt des Weiteren ein erfindungsgemäßes Laminat 1, das ebenfalls eine Deckfolie 2 der vorstehend beschriebenen Art aufweist. Diese ist hier jedoch, anders als bei der Ausgestaltung gemäß Fig. 2, auf einer weiteren Zwischenfolie 7 aufgebracht, bei der es sich bevorzugt um eine PVB-Folie in einer Dicke von 0,1-1 mm handeln kann, sie kann aber auch aus demselben Kunststoffmaterial wie die Deckfolie 2 sein. Diese Zwischenfolie 7 ist auf der Solarzellenfolie 3 der vorbeschriebenen Art aufgebracht, dient also als Schutzfolie für dieselbe zur Deckfolie 2 hin.

Die Solarzellenfolie 3 ist wiederum, ähnlich wie in Fig. 2, auf einer ersten Zwischenfolie 6, bevorzugt wieder eine PVB-Folie bzw. entsprechend der Zwischenfolie 7 ausgeführt, aufgebracht, die ihrerseits wiederum auf der Trägerschicht 4 aufgebracht ist. Auch hier ergibt sich insgesamt ein äußerst dünner Laminataufbau, der nach wie vor hinreichend flexibel ist, da sämtlich verwendete Folien oder Schichten extrem dünn und ihrerseits flexibel sind.

Auch hier wird ein Klebemittel (5) aufgebracht.

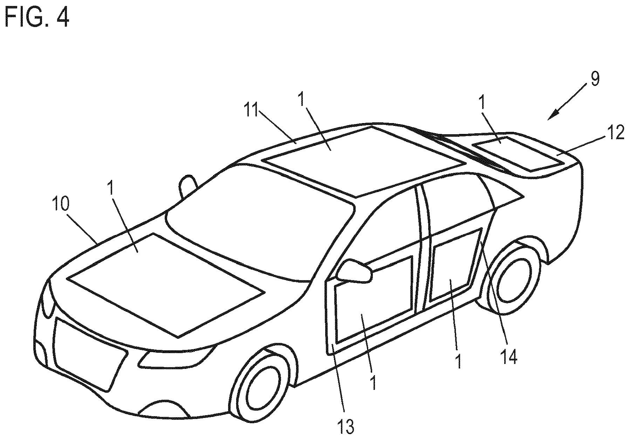

Fig. 4 zeigt ein erfindungsgemäßes Kraftfahrzeug 9, bei dem es sich entweder um ein reines Elektrofahrzeug handelt, das also nur elektrisch betrieben wird, oder um ein Hybridfahrzeug. Wie gezeigt ist die Außenfläche 4 des Kraftfahrzeugs 9 großflächig an mehreren Stellen mit einem erfindungsgemäßen Laminat 1 belegt. So kann exemplarisch das Laminat 1 auf die Front- oder Motorhaube 10 aufgeklebt werden, es kann auch großflächig auf das Dach 11 oder die Kofferraum- oder Heckklappe 12 aufgeklebt werden. Die Befestigung an diesen Positionen ist vorteilhaft, als dort ein sehr guter Lichteinfall während des Tages gewährleistet ist.

Zusätzlich oder alternativ kann die Anordnung des Laminats aber auch an den Türen 13, 14 erfolgen.

Das oder die Laminate 1, die auch als Solarzellenlaminate oder flexible Solarzellenmodule bezeichnet werden können, werden bevorzugt direkt mit dem Hochvolt-Stromkreis, über den das Kraftfahrzeug 9 elektrisch betrieben respektive fahren kann, gekoppelt, das heißt, dass der über sie erzeugte "Solarstrom" direkt in diesen Hochvolt-Stromkreis eingespeist werden kann, so dass die Reichweite von elektrisch angetriebenen Fahrzeugen erhöht werden kann. Denkbar ist es auch, diesen "Solarstrom" in einem entsprechenden Energiespeicher einzuspeichern bzw. zwischen zu puffern und bei Bedarf zu nutzen.

## Patentansprüche

1. Photovoltaisch aktives, flexibles Laminat, geeignet zur direkten Anbringung auf nicht ebenflächigen Oberflächen, mindestens umfassend eine die Laminatoberseite bildende, für einfallende Lichtstrahlung transparente Deckfolie (2), eine photovoltaisch aktive Solarzellenfolie (3) bestehend aus einer Trägerfolie und einer auf dieser aufgebrachten Beschichtung aus einem photovoltaisch aktiven Material sowie eine Trägerschicht (4),
wobei auf der Trägerschicht (4) ein Klebemittel (5), über das das Laminat (1) auf einer Fläche verklebbar ist, und das mit einer abziehbaren Schutzfolie belegt ist, angeordnet ist, **dadurch gekennzeichnet, dass** die Trägerschicht (4) aus einem Faserverbundwerkstoff ist, und dass die Deckfolie (2) eine Dicke von bis zu 1 mm, die Solarzellenfolie (3) eine Dicke zwischen 0,06 - 2 mm, und die Trägerschicht (4) eine Dicke zwischen 0,8 - 3 mm aufweist.

2. Photovoltaisch aktives Laminat nach Anspruch 1,
**dadurch gekennzeichnet,**
**dass** die Deckfolie (2) aus Polyurethan, Styrol-Acrylnitril, Polycarbonat oder Polyamid ist.

3. Photovoltaisch aktives Laminat nach Anspruch 1 oder 2,
**dadurch gekennzeichnet,**
**dass** die Trägerschicht (4) aus glasfaserverstärktem oder kohlefaserverstärktem Kunststoff ist.

4. Photovoltaisch aktives Laminat nach einem der vorangehenden Ansprüche,
**dadurch gekennzeichnet,**
**dass** die Deckfolie (2) direkt auf der Solarzellenfolie (3) und diese direkt auf der Trägerschicht (4) angeordnet ist.

5. Photovoltaisch aktives Laminat nach einem der Ansprüche 1 bis 3,
**dadurch gekennzeichnet,**
**dass** wenigstens eine Zwischenfolie (6, 7) vorgesehen ist, die zwischen der Deckfolie (2) und der Trägerschicht (4) angeordnet ist.

6. Photovoltaisch aktives Laminat nach Anspruch 5,
**dadurch gekennzeichnet,**
**dass** die Zwischenfolie (6) zwischen der Solarzellenfolie (3) und der Trägerschicht (4) angeordnet ist.

7. Photovoltaisch aktives Laminat nach Anspruch 5 oder 6
**dadurch gekennzeichnet,**
**dass** zwischen der Deckfolie (2) und der Solarzellenfolie (3) und zwischen der Solarzellenfolie (3) und der Trägerschicht (4) eine Zwischenfolie (6, 7) angeordnet ist.

8. Photovoltaisch aktives Laminat nach einem der Ansprüche 5 bis 7,
**dadurch gekennzeichnet,**
**dass** die Zwischenfolie (6, 7) aus demselben Material wie die Deckfolie (2) ist.

9. Photovoltaisch aktives Laminat nach einem der Ansprüche 5 bis 7,
**dadurch gekennzeichnet,**
**dass** die Zwischenfolie (6, 7) aus Polyvinylbutyral ist.

10. Photovoltaisch aktives Laminat nach einem der Ansprüche 5 bis 8,
**dadurch gekennzeichnet,**
**dass** die Zwischenfolie (6, 7) eine Dicke von wenigstens 0,1 mm, insbesondere zwischen 0,1 - 1 mm aufweist.

11. Photovoltaisch aktives Laminat nach einem der vorangehenden Ansprüche,
**dadurch gekennzeichnet,**
**dass** das Klebemittel (5) ein unmittelbarer Klebstoffauftrag oder eine Klebefolie, insbesondere eine doppelseitige Klebefolie ist.

12. Kraftfahrzeug, bei dem wenigstens eine Außenfläche mit einem photovoltaisch aktiven Laminat (1) nach einem der vorangehenden Ansprüche belegt ist

13. Kraftfahrzeug nach Anspruch 12,
**dadurch gekennzeichnet,**
**dass** das Laminat (1) mittels eines Klebemittels, insbesondere einer Klebefolie, auf die Außenfläche geklebt ist.

## Claims

1. Photovoltaically active, flexible laminate suitable for direct attachment to nonplanar surfaces, at least comprising a cover film (2) which forms the top surface of the laminate and which is transparent to incident light radiation, a photovoltaically active solar cell film (3) consisting of a support film and a coating of a photovoltaically active material applied thereto, and a support layer (4), wherein an adhesive (5) via which the laminate (1) can be adhered to a surface and which is covered with a removable protective film is disposed on the support layer (4), **characterised in that** the support layer (4) is made of a fibre composite material and that the cover film (2) has a thickness of up to 1 mm, the solar cell film (3) has a thickness of between 0.06 mm and 2 mm, and the support layer (4) has a thickness of between 0.8 mm and 3 mm.

2. Photovoltaically active laminate according to claim 1,
**characterised in that**
the cover film (2) is made of polyurethane, styrene-acrylonitrile, polycarbonate or polyamide.

3. Photovoltaically active laminate according to claim 1 or 2,
**characterised in that**
the support layer (4) is made of glass fibre-reinforced or carbon fibre-reinforced plastic.

4. Photovoltaically active laminate according to any of the preceding claims,
**characterised in that**
the cover film (2) is disposed directly on the solar cell film (3), and the latter is disposed directly on the support layer (4).

5. Photovoltaically active laminate according to any of claims 1 to 3,
**characterised in that**
at least one intermediate film (6, 7) is provided which is disposed between the cover film (2) and the support layer (4).

6. Photovoltaically active laminate according to claim 5,
**characterised in that**
the intermediate film (6) is disposed between the solar cell film (3) and the support layer (4).

7. Photovoltaically active laminate according to claim 5 or 6,
**characterised in that**
an intermediate film (6, 7) is disposed between the cover film (2) and the solar cell film (3) and between the solar cell film (3) and the support layer (4).

8. Photovoltaically active laminate according to any of claims 5 to 7,
**characterised in that**
the intermediate film (6, 7) is made of the same material as the cover film (2).

9. Photovoltaically active laminate according to any of claims 5 to 7,
**characterised in that**
the intermediate film (6, 7) is made of polyvinyl butyral.

10. Photovoltaically active laminate according to any of claims 5 to 8,
**characterised in that**
the intermediate film (6, 7) has a thickness of at least 0.1 mm, in particular between 0.1 and 1 mm.

11. Photovoltaically active laminate according to any of the preceding claims,
**characterised in that**
the adhesive (5) is a direct adhesive application or an adhesive film, in particular a double-sided adhesive film.

12. Motor vehicle in which at least one outer surface is covered with a photovoltaically active laminate (1) according to any of the preceding claims.

13. Motor vehicle according to claim 12,
**characterised in that**
the laminate (1) is adhered to the outer surface by means of an adhesive, in particular an adhesive film.

## Revendications

1. Stratifié souple à action photovoltaïque, adéquat pour une installation directe sur des surfaces non planes, comprenant au moins un film décoratif (2) formant la face supérieure de stratifié et transparent pour un rayonnement lumineux incident, un film à cellules solaires à action photovoltaïque (3) se composant d'un film porteur et d'un revêtement appliqué sur celui-ci en matériau à action photovoltaïque ainsi qu'une couche support (4), dans lequel sur la couche support (4) est disposé un adhésif (5), par l'intermédiaire duquel le stratifié (1) peut être collé sur une surface, et qui est revêtu d'un film de protection amovible, **caractérisé en ce que** la couche support (4) est en matériau composite de fibres et **en ce que** le film décoratif (2) présente une épaisseur allant jusqu'à 1 mm, le film à cellules solaires (3) présente une épaisseur comprise entre 0,06 et 2 mm et la couche support (4) présente une épaisseur comprise entre 0,8 et 3 mm.

2. Stratifié à action photovoltaïque selon la revendication 1,
**caractérisé en ce que**
le film décoratif (2) est en polyuréthane, styrène-acrylonitrile, polycarbonate ou polyamide.

3. Stratifié à action photovoltaïque selon la revendication 1 ou 2,
**caractérisé en ce que**
la couche support (4) est en matériau synthétique renforcé en fibres de verre ou renforcé en fibres de carbone.

4. Stratifié à action photovoltaïque selon l'une quelconque des revendications précédentes,
**caractérisé en ce que**
le film décorateur (2) est disposé directement sur le film à cellules solaires (3) et celui-ci est disposé directement sur la couche support (4).

5. Stratifié à action photovoltaïque selon l'une quelconque des revendications 1 à 3,
**caractérisé en ce que**
au moins un film intermédiaire (6, 7) est prévu, qui est disposé entre le film décoratif (2) et la couche support (4).

6. Stratifié à action photovoltaïque selon la revendication 5,
**caractérisé en ce que**
le film intermédiaire (6) est disposé entre le film à cellules solaires (3) et la couche support (4).

7. Stratifié à action photovoltaïque selon la revendication 5 ou 6,
**caractérisé en ce que**
un film intermédiaire (6, 7) est disposé entre le film décoratif (2) et le film à cellules solaires (3) et entre le film à cellules solaires (3) et la couche support (4).

8. Stratifié à action photovoltaïque selon l'une quelconque des revendications 5 à 7,
**caractérisé en ce que**
le film intermédiaire (6, 7) est du même matériau que le film décoratif (2).

9. Stratifié à action photovoltaïque selon l'une quelconque des revendications 5 à 7,
**caractérisé en ce que**
le film intermédiaire (6, 7) est en butyral de polyvinyle.

10. Stratifié à action photovoltaïque selon l'une quelconque des revendications 5 à 8,
**caractérisé en ce que**
le film intermédiaire (6, 7) présente une épaisseur d'au moins 0,1mm, en particulier comprise entre 0,1 et 1 mm.

11. Stratifié à action photovoltaïque selon l'une quelconque des revendications précédentes,
**caractérisé en ce que**
l'adhésif (5) est un enduit adhésif direct ou un film adhésif, en particulier un film adhésif double face.

12. Véhicule à moteur, dans lequel au moins une surface externe est revêtue d'un stratifié à action photovoltaïque (1) selon l'une quelconque des revendications précédentes.

13. Véhicule à moteur selon la revendication 12,
**caractérisé en ce que**
le stratifié (1) est collé sur la surface externe au moyen d'un adhésif, en particulier d'un film adhésif.
